# EUROPÄISCHE PATENTANMELDUNG

(11) **EP 1 933 391 A1**
(43) Veröffentlichungstag der Anmeldung: **18.06.2008**
(21) Anmeldenummer: 06125817.4
(22) Anmeldetag: 11.12.2006
(51) Int. Cl.: H01L 31/18

(54) **Verfahren zur Herstellung einer SiN:H-Schicht auf einem Substrat**

(71) Anmelder: Applied Materials, Inc., Santa Clara, CA 95054 (US)
(72) Erfinder: Trassl, Roland, 35392, Gießen (DE); Sauer, Andreas, 63762, Grossostheim (DE); Wieder, Stephan, 60385, Frankfurt (DE)
(74) Vertreter: Schickedanz, Willi

(57) **Zusammenfassung**

Die Erfindung betrifft ein Verfahren zur Herstellung einer SiN:H-Schicht auf einem Substrat, das Licht in elektrische Spannung umwandelt, wobei ein Silizium enthaltendes Target zerstäubt wird und wenigstens ein reaktives Gas in den Raum zwischen Target und Substrat eingeführt wird. Das Silizium enthaltende Target ist dabei rohrförmig ausgebildet und besteht aus einer Si-Basislegierung mit einem Al-Gehalt von 2 bis 50 Gewichtsprozent.

## Beschreibung

Die Erfindung betrifft ein Verfahren zur Herstellung einer SiN:H-Schicht auf einem Substrat sowie die Verwendung eines Rohrtargets mit einer Si-Basislegierung für die Herstellung einer SiN:H-Schicht auf einer Solarzelle.

Elektrische Energie kann mittels photovoltaischer Elemente direkt aus dem Sonnenlicht gewonnen werden. Der photovoltaische Effekt beruht auf der Erzeugung einer elektromotorischen Kraft durch die Absorption ionisierender Strahlung. Vorrichtungen, die den photovoltaischen Effekt verwenden, um eine elektrische Spannung mit Hilfe von Sonnenlicht zu erzeugen, werden Solarzellen genannt. Solarzellen sind von Fotozellen zu unterscheiden, die bei Einstrahlung von Licht ihren elektrischen Widerstand ändern und als Lichtmessgeräte in Kameras verwendet werden. Solche Fotozellen erzeugen keine elektrische Energie und benötigen eine Batterie, um betriebsfähig zu sein.

Solarzellen gibt es etwa seit 1955 und sie wurden zunächst in Satelliten und später, 1960 bis 1970, auch in terrestrischen Systemen verwendet. Seit 1975 finden Solarzellen überwiegend in terrestrischen Systemen Anwendung. Sie bestehen in der Regel aus einem Halbleitermaterial, vorzugsweise aus Silizium. Es kommen jedoch auch Halbleiter wie GaAs oder CdTe (Cadmium-Tellurid) in Frage.

Im Prinzip tritt der Solarzelleneffekt allerdings auch bei einer Verbindung zweier unterschiedlicher Materialien auf, beispielsweise bei einer Verbindung zwischen einem Metall und einem Halbleiter.

Damit eine elektrische Spannung aufgrund von Sonnenstrahlung entsteht, müssen drei Vorgänge stattfinden. Zunächst muss ein Photon im aktiven Teil des Materials absorbiert werden und bewirken, dass Elektronen auf ein höheres Energieniveau gebracht werden. Sodann müssen die Ladungsträger, die durch die Absorption erzeugt wurden, physisch getrennt und zu den Kanten der Solarzellen transportiert werden. Schließlich müssen die Ladungsträger aus den Solarzellen abgeleitet und auf einen Verbraucher gegeben werden, bevor sie rekombinieren können.

Der Wirkungsgrad einer Solarzelle ist umso größer, je mehr von dem aufgefangenen Licht in elektrische Energie umgesetzt wird. Es muss also z. B. vermieden werden, dass das auf die Solarzelle auftreffende Licht reflektiert wird.

Damit eine Lichtreflexion vermindert oder ausgeschlossen wird, werden die Solarzellen mit einer Beschichtung versehen, die aus einem dielektrischen Material besteht. Dielektrische Schichten sind nahezu absorptionsfrei und geeignet für die Umverteilung der Energie zwischen Reflexion und Transmission, wenn sie zwischen zwei Medien - z. B. Solarzelle und Luft - eingeschoben werden.

Bei Solarzellen, die aus multikristallinem Silizium bestehen, wird in der Regel als Antireflexionsschicht ein Material aus SiNₓ:H verwendet. Dieses mit Wasserstoff dotierte Siliziumnitrid hat einen niedrigen Reflexions- und einen niedrigen Absorptionsgrad, sodass es das auftreffende Licht fast vollständig durchlässt.

Das wasserstoffhaltige Siliziumnitrid wird üblicherweise mittels eines PECVD-Verfahrens auf die Solarzellen aufgebracht (PECVD = Plasma enhanced chemical vapor deposition).

Es ist indessen auch bereits bekannt, SiN:H-Antireflexionsschichten mittels Sputtern auf Solarzellen aufzubringen (Wolke et al.: SiN:H Anti-Reflection Coatings for C-Si Solar Cells by Large Scale Inline Sputtering, 19th European Photovoltaic Solar Energy Conference, 7-11 June 2004, Paris, Seiten 419 - 422). Dabei werden planare Targets aus Silizium zerstäubt und ein Reaktivgas aus Stickstoff und Wasserstoff oder Ammoniak in die Sputterkammer zugeführt, sodass sich aus dem gesputterten Silizium und dem Reaktivgas SiNₓ:H bildet. Das verwendete Silizium muss dabei hochrein sein, weil z. B. Verunreinigungen mit Eisen oder Kupfer in den Absorber diffundieren können und so den Wirkungsgrad reduzieren.

Planare Targets sind in der Regel weniger effizient als rotierende Rohr-Targets, da ca. 75 % des Targetmaterials bei planaren Targets nicht für die Schichterzeugung genutzt werden können. Rohr-Targets sind indessen schwerer herzustellen als planare Targets, und zwar insbesondere Rohr-Targets aus dotiertem Silizium.

Es ist indessen ein Verfahren zum Herstellen eines rohrförmigen Sputtertargets aus einer Si-Basislegierung mit einem Al-Gehalt von 5 bis 50 Gewichtsprozent bekannt (DE 102 53 319 B3). Bei diesem Verfahren wird das Targetmaterial gießtechnisch durch Schmelzen und Abgießen im Vakuum hergestellt, wobei der Guss in einer hohlzylinderförmigen Gussform mit einem Grafitkern erfolgt.

Der Erfindung liegt die Aufgabe zugrunde, die Effektivität beim Aufbringen einer Antireflexschicht aus SiN:H auf Solarzellen zu erhöhen.

Diese Aufgabe wird gemäß den Merkmalen des Patentanspruchs 1 gelöst.

Die Erfindung betrifft somit ein Verfahren zur Herstellung einer SiN:H-Schicht auf einem Substrat, das Licht in elektrische Spannung umwandelt, wobei ein Silizium enthaltendes Target zerstäubt wird und wenigstens ein reaktives Gas in den Raum zwischen Target und Substrat eingeführt wird. Das Silizium enthaltende Target ist dabei rohrförmig ausgebildet und besteht aus einer Si-Basislegierung mit einem Al-Gehalt von 2 bis 50 Gewichtsprozent.

Der mit der Erfindung erzielte Vorteil besteht insbesondere darin, dass die Standzeit der Sputteranlage wegen des größeren Materialvorrats im Vergleich zu planaren Targets erhöht wird. Außerdem werden die Kosten für die Herstellung von Solarzellen gesenkt. Wie sich überraschend herausgestellt hat, verschlechtert die Beigabe von Aluminium zum Silizium die optischen Eigenschaften der auf die Solarzelle aufgesputterten Schicht kaum.

Bei einer vorteilhaften Ausgestaltung der Erfindung beträgt der Al-Gehalt von 2 bis 50 Gewichtsprozent.

Bei einer weiteren vorteilhaften Ausgestaltung der Erfindung ist das rohrförmige Target aus zwei Halbrohren gebildet, die auf einem Trägerrohr befestigt werden.

Bei einer weiteren vorteilhaften Ausgestaltung der Erfindung erfolgt das Befestigen der beiden Halbrohre mittels eines Klebers.

Bei einer weiteren vorteilhaften Ausgestaltung der Erfindung wird das rohrförmige Target während des Sputterbetriebs um seine Längsachse gedreht.

Bei einer weiteren vorteilhaften Ausgestaltung der Erfindung besteht das reaktive Gas aus Wasserstoff und Stickstoff oder es enthält Wasserstoff und Stickstoff.

Bei einer weiteren vorteilhaften Ausgestaltung der Erfindung ist oder enthält das reaktive Gas Ammoniak.

Bei einer weiteren vorteilhaften Ausgestaltung der Erfindung besteht das Target aus Silizium.

Bei einer weiteren vorteilhaften Ausgestaltung der Erfindung besteht das Target aus GaAs.

Bei einer weiteren vorteilhaften Ausgestaltung der Erfindung besteht das Target aus CdTe.

Wird die SiN:H-Schicht auf einer Solarzelle mittels Sputtern hergestellt, ist es vorteilhaft, ein Rohrtarget zu verwenden, das aus einer Si-Basislegierung mit einem Al-Gehalt von 2 bis 50 Gewichtsprozent besteht.

## Patentansprüche

1. Verfahren zur Herstellung einer SiN:H-Schicht auf einem Substrat, das Licht in elektrische Spannung umwandelt, wobei ein Silizium enthaltendes Target zerstäubt wird und wenigstens ein reaktives Gas in den Raum zwischen Target und Substrat eingeführt wird, **dadurch gekennzeichnet, dass** das Target rohrförmig ausgebildet ist und aus einer Si-Basislegierung mit einem Al-Gehalt von 2 bis 50 Gewichtsprozent besteht.

2. Verfahren nach Anspruch 1, **dadurch gekennzeichnet, dass** der Al-Gehalt von 2 bis 10 Gewichtsprozent beträgt.

3. Verfahren nach Anspruch 1, **dadurch gekennzeichnet, dass** das rohrförmige Target aus zwei Halbrohren gebildet wird, die auf einem Trägerrohr befestigt werden.

4. Verfahren nach Anspruch 3, **dadurch gekennzeichnet, dass** das Befestigen der beiden Halbrohre mittels eines Klebers erfolgt.

5. Verfahren nach Anspruch 1, **dadurch gekennzeichnet, dass** das rohrförmige Target während des Sputterbetriebs um seine Längsachse gedreht wird.

6. Verfahren nach Anspruch 1, **dadurch gekennzeichnet, dass** das reaktive Gas Wasserstoff und Stickstoff ist oder enthält.

7. Verfahren nach Anspruch 1, **dadurch gekennzeichnet, dass** das reaktive Gas Ammoniak ist oder enthält.

8. Verfahren nach Anspruch 1, **dadurch gekennzeichnet, dass** das Target aus Silizium besteht.

9. Verfahren nach Anspruch 1, **dadurch gekennzeichnet, dass** das Target aus GaAs besteht.

10. Verfahren nach Anspruch 1, **dadurch gekennzeichnet, dass** das Target aus CdTe besteht.

11. Verwendung eines Rohrtargets, das aus einer Si-Basislegierung mit einem Al-Gehalt von 2 bis 50 Gewichtsprozent besteht, beim Sputtern für die Herstellung einer SiN:H-Schicht auf einer Solarzelle.
